# EUROPÄISCHE PATENTSCHRIFT

(11) **EP 0 935 818 B1**
(45) Veröffentlichungstag und Bekanntmachung des Hinweises auf die Patenterteilung: **12.12.2007**
(21) Anmeldenummer: 98916835.6
(22) Anmeldetag: 04.03.1998
(51) Int. Cl.: H01L 25/16

(54) **ELEKTRONISCHES STEUERGERÄT**
ELECTRONIC CONTROL APPARATUS
APPAREIL DE COMMANDE ELECTRONIQUE

(30) Priorität: 28.06.1997 DE 19727548
(43) Veröffentlichungstag der Anmeldung: 18.08.1999
(73) Patentinhaber: ROBERT BOSCH GMBH, 70442 Stuttgart (DE)
(72) Erfinder: HERZOG, Achim, D-71522 Backnang (DE); SPACHMANN, Jürgen, D-74372 Sersheim (DE); WAGNER, Uwe, D-71665 Vaihingen (DE); RAICA, Thomas, D-72379 Hechingen (DE)
(86) Internationale Anmeldenummer: PCT/DE1998/000621
(87) Internationale Veröffentlichungsnummer: WO 1999/000845

(56) Entgegenhaltungen:
- EP-A- 0 278 432
- EP-A- 0 516 149
- EP-A- 0 578 108
- EP-A- 0 697 732
- DE-A- 2 753 145
- DE-A- 3 933 084
- DE-A- 4 035 526
- US-A- 5 488 256

## Beschreibung

### Stand der Technik

Die Erfindung betrifft ein elektronisches Steuergerät mit den im Oberbegriff des Anspruchs 1 angegebenen Merkmalen.

Aus der DE 36 24 845 C2 ist ein Steuergerät für eine elektronische Zündanlage bekannt geworden, das einen an dem Gehäuse des Steuergerätes festgelegten Gerätestecker aufweist, der mit einer Vielzahl von Kontaktelementen versehen ist. Die isoliert durch das Gehäuse geführten Kontaktelemente des Gerätesteckers sind innerhalb des Gehäuses mit einer auf einer Hybridplatte angeordneten Steuerschaltung über Bonddrähte verbunden und außerhalb des Gehäuses in Form von Steckerfahnen ausgebildet, die mit entsprechend ausgebildeten Gegenkontaktelementen eines Kabelbaumsteckers koppelbar sind. Ein derartiges Steuergerät wird üblicherweise im Motorraum eines Kraftfahrzeuges eingebaut. Über den Kabelbaumstecker wird die elektrische Verbindung zu den Motorkomponenten, wie z.B. den Zündspulen, am Motor angeordneten Sensoren oder Stellelementen oder die Verbindung zu anderenorts im Kraftfahrzeug angeordneten Komponenten hergestellt.

Aus der US 5 488 256 A ist eine Halbleiter-Anordnung bekannt, bei der Substrate verwendet werden, die über eine Verlängerung der Leiterbahnen elektrisch miteinander verbunden sind. Die Leistungshalbleiter, wie IGBTs (Insulated Gate Bipolar Transistors), sind auf einem ersten Substrat aufgebracht, die Steuerschaltung auf einem zweiten Substrat, wobei die beiden Substrate separat produziert werden und unterschiedliche Leiterbahndicken und -Layouts aufweisen.

Aus der DE 39 33 084 A1 ist ein Gehäuse für eine elektronische, mit Anschlußsteckern versehene Schaltung, insbesondere für eine Steuergerätelektronik einer Brennkraftmaschine eines Fahrzeugs, bekannt, mit einem Kühlrahmen, an dem eine die elektronische Schaltung aufweisende Leiterplatte befestigt ist und der mindestens einen Kühlabschnitt aufweist, mit dem an der Leiterplatte angeschlossene LeistungsBauelemente wärmeleitend verbunden sind sowie mit einer die Leiterplatte umfangenden Abdeckung. Bei dieser Schaltung sind die Leistungsbauelemente und die elektronische Steuerungsschaltung auf einem Substrat aufgebracht.

Nachteilig bei dem bekannten Stand der Technik ist, daß alle für die verschiedenen Funktionen des Steuergerätes benötigten Bauelemente und die zugehörigen Anschlußleiterbahnen auf dem im Steuergerät angeordneten Hybrid angeordnet sind. Da einige dieser Bauelemente, insbesondere Leistungsbauelemente oder Kondensatoren relativ groß sind, nehmen sie auf der Oberseite des Hybrids viel Platz in Anspruch. Weiterhin benötigen beispielsweise Leistungsendstufen niederohmige Anschlußleitungen, wobei die Leiterbahnen teilweise umständlich an diese großen Bauelemente herangeführt werden, was die elektromagnetische Verträglichkeit verschlechtert, die Leiterbahnführung erschwert und zu einer unerwünschten Vergrößerung des Hybrids führt. Bauelemente wie z.B. Zündungstransistoren sind auf Trägerbausteinen aufgelötet, die wiederum auf dem Substrat montiert und kontaktiert sind, wodurch sich der Platzbedarf weiter vergrößert. Nun besteht aber zunehmend der Wunsch nach immer kleineren Steuergeräten, die im Motorraum nur wenig Platz in Anspruch nehmen. Erschwerend kommt hinzu, daß die Gerätestecker der Steuergeräte immer mehr Kontaktelemente aufweisen, die mit Anschlüssen der Schaltung auf dem Hybrid kontaktiert werden müssen, so daß es bei einer Verkleinerung des Hybrids schwieriger wird, alle Anschlüsse in unmittelbarer Nähe des Gerätestekkers auf dem Hybrid zu plazieren. Dabei ist insbesondere nachteilig, daß die Anschlußleiterbahnen der Leistungsbauelemente zur Leitung von im Vergleich zu den Signalströmen höheren Leistungsströmen ausgelegt sein müssen und deshalb einen größeren Querschnitt aufweisen, so daß der Platzbedarf auf dem Hybrid mit der Anzahl der Anschlußleiterbahnen für Leistungsbauelemente noch weiter zunimmt.

Weiterhin muß die von den Leistungsbauelementen erzeugte Wärme auf das Gehäuse des Steuergerätes abgeführt werden, um eine Überhitzung zu vermeiden. Da keramische Mehrschichtsubstrate, wie z.B. LTCC-Substrate, eine schlechte Wärmeleitfähigkeit aufweisen, wird dies in der Regel dadurch erreicht, daß in dem Substrat thermische Durchkontaktierungen, sogenannte Vias, vorgesehen sind. Mit zunehmender Anzahl an Vias wird aber die Entflechtung der Leiterbahnführung des Mehrschichtsubstrats zunehmend aufwendiger.

### Vorteile der Erfindung

Das erfindungsgemäße Steuergerät mit den kennzeichnenden Merkmalen des Anspruchs 1 vermeidet die zuvor erwähnten Nachteile in zufriedenstellendem Maße. Durch ein zweites, in dem Steuergerätegehäuse angeordnetes Substrat, auf welchem Leistungsbauelemente mit ihren Anschlußleiterbahnen angeordnet sind, wird vorteilhaft erreicht, daß bei hochpoligen Gerätesteckern mit einer großen Anzahl von Kontaktelementen die Anbindung der Kontaktelemente an die elektronische Schaltung durch eine flexiblere Leiterbahnführung erleichtert wird. Große Bauelemente, wie z.B. Tantalkondensatoren, Leistungsbauelemente, wie z.B. Zündungstransistoren, können ohne einen zusätzlichen Trägerbaustein direkt auf dem zweiten Substrat aufgebracht werden. Das erste Substrat kann deshalb kleiner aufgeführt werden, was insbesondere bei teuren LTCC-Substraten (Low Temperatur Cofired Ceramic) wünschenswert ist. Besonders vorteilhaft ist die Möglichkeit, das zweite Substrat aus einem anderen Material als das erste Substrat zu fertigen. So kann zum Beispiel als erstes Substrat ein mit einer Hybridschaltung versehenes LTCC-Substrat und als zweites Substrat ein kostengünstiges DBC-Substrat (Direct Bonded Copper) verwendet werden. Da die Herstellung von großflächigen, metallischen Leiterbahnen auf dem DBC-Substrat keine Schwierigkeiten bereitet, können die Leistungsströme vorteilhaft über die niederohmigen Anschlußleiterbahnen des DBC-Substrats mit den dort aufgebrachten Leistungsbauelementen verbunden werden. Hierdurch wird nicht nur das Leiterbahn-Layout vereinfacht, sondern darüber hinaus auch eine Verbesserung der elektromagnetischen Verträglichkeit (EMV-Schutz) erreicht. Weiterhin besteht die Möglichkeit, das zweite Substrat aus einem gut wärmeleitenden Material wie z.B. Al₂O₃ zu fertigen, so daß eine verbesserte Wärmeableitung der von den Leistungsbauelementen erzeugten Wärme erreicht wird, ohne daß hierfür thermische Vias vorgesehen werden müssen.

In einem elektronischen Steuergerät, in dem zwei Gerätestecker mit Kontaktelementen angeordnet sind, von denen einige für die Leitung von Leistungsströmen ausgelegt sind und die ohne Zwischenschaltung von Bauelementen durch das Steuergerät durchgeschleift werden müssen, sind auf dem zweiten Substrat zusätzlich Durchführungsleiterbahnen vorzusehen, welche die Kontaktelemente der beiden Stecker direkt miteinander verbinden. Hierdurch wird vorteilhaft erreicht, daß z.B. keine elektrischen Stromschienen oder aufwendig anzuschließenden Kabelverbindungen zur Durchführung der Leistungsströme durch das Steuergerät benötigt werden.

Weitere vorteilhafte Ausgestaltungen und Weiterbildungen der Erfindung werden durch die in den Unteransprüchen angegebenen Merkmale ermöglicht.

Da das zweite Substrat räumlich getrennt von dem ersten Substrat in dem Steuergerätegehäuse angeordnet ist und die Kontaktelemente des wenigstens einen Gerätesteckers mit beiden Substraten verbunden werden müssen, ist es zur Überbrükkung kleinerer Abstände vorteilhaft, die Anschlußleiterbahnen und die Durchführungsleiterbahnen des zweiten Substrats über Bonddrähte mit den Kontaktelementen zu verbinden. Das zweite Substrat ist hierfür in der Nähe der Leistungsströme führenden Hochstrom-Kontaktelemente des wenigstens einen Gerätesteckers angeordnet.

Zusätzlich können vorteilhaft auch Leistungsströme führende Leitungen auf dem zweiten Substrat vorgesehen sein, die z.B. über Bonddrähte mit Kontaktflächen auf dem ersten Substrat verbunden sind, welche Kontaktflächen wiederum auf kurzem Wege mit einem Leistungbauelement auf dem ersten Substrat leitend verbunden sind.

Weiterhin ist es zur Vereinfachung der Leiterbahnführung auf dem ersten Substrat vorteilhaft, außer den Leistungsströme leitenden Leiterbahnen zusätzlich auch einige Signalströme führende Leiterbahnen auf dem zweiten Substrat anzuordnen. Hierdurch kann z.B. erreicht werden, daß die Signalströme von den Kontaktelementen eines Gerätesteckers über das zweite Substrat auf einfache Weise an weiter entfernt liegende Schaltungsteile des ersten Substrats herangeführt werden können.

Vorteilhaft ist weiterhin, daß große Bauelemente, wie z.B. Tantal-Kondensatoren direkt auf dem zweiten Substrat aufgebracht und dort mit den Enden der Leiterbahnen verbunden werden können, da derartige Bauelemente auf dem ersten Substrat zuviel Platz beanspruchen würden.

Weiterhin ist es vorteilhaft, als zweites Substrat ein DBC-Substrat (Direct Bonded Copper) vorzusehen, das preiswert und einfach herzustellen ist und gute Wärmeleiteigenschaften aufweist. Derartige Substrate sind besonders gut zur Wäremableitung extremer Belastungsspitzen geeignet. Einzelne Bauelemente, wie z.B. Chip-Dioden mit der Anode wahlweise auf der Rückseite oder der Vorderseite können mit Hilfe einer Bondoption auf das DBC-Substrat aufgebracht werden und sind dadurch flexibel einsetzbar.

### Zeichnung

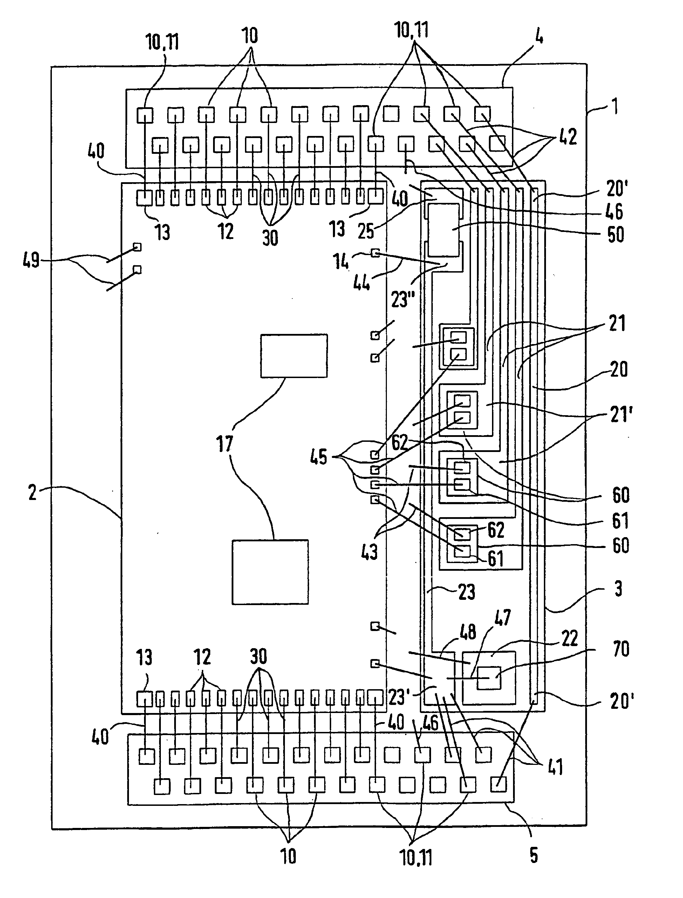

Ein Ausführungsbeispiel der Erfindung ist in der Zeichnung dargestellt und wird in der nachfolgenden Beschreibung näher erläutert. Fig. 1 zeigt schematisch einen Ausschnitt des Innenteils eines Steuergerätes mit einem Hybrid und einem DBC-Substrat und zwei an dem Gerätegehäuse festgelegten Gerätesteckern.

### Beschreibung des Ausführungsbeispiels

Fig. 1 zeigt schematisch das Innenteil des Gehäuses 1 eines Steuergerätes, welches z.B. zur elektronischen Steuerung der Zündung einer Brennkraftmaschine in einem Kraftfahrzeug verwandt wird. Das Gehäuse 1 umfaßt eine nicht dargestellte ringförmige Seitenwand und ein Bodenteil mit einem darauf aufgeklebten Substrat 2. Das Gehäuse 1 ist mit einem nicht gezeigten Deckel verschließbar, so daß das Substrat 2 geschützt in dem Gehäuse angeordnet ist. Vorzugsweise ist das Substrat 2 ein mit einer Mikrohybridschaltung versehenes LTCC-Substrat. Es können aber auch andere Keramik-Substrate oder auch Leiterplatten-Substrate verwandt werden. Auf dem LTCC-Substrat ist eine elektronische Steuerschaltung mit Bauelementen 17, wie z.B. Widerständen, Kondensatoren, IC's oder Mikroprozessoren sowie diese verbindende, in Fig. 1 nicht dargestellte Leiterbahnen, die in bekannter Weise aus elektrischer Leitpaste auf bzw. in dem LTCC-Substrat hergestellt sind. Auf der Oberseite des Substrats 2 sind Anschlußflächen 12,13 für den elektrischen Anschluß der Schaltung an zwei Gerätestecker 4,5 vorgesehen. Die Gerätestecker 4,5 sind in je einer Öffnung des Bodenteils des Gehäuses 1 an gegenüberliegenden Seiten des Substrats 2 eingelassen und weisen eine Vielzahl von als Steckerstiften ausgebildeten Kontaktelementen 10 auf. Die Kontaktelemente 10 sind auf der von dem Substrat abweisenden Außenseite des Gehäuses 1 aus diesem herausgeführt und dort mit den Kontaktelementen von entsprechend ausgebildeten Gegensteckern koppelbar. Mit dem Gegenstecker zu dem Gerätestecker 4, dem sogenannten Motorstecker, ist ein Kabelbaum verbunden, der z.B. mit den Zündspulen des Kraftfahrzeugs verbunden ist. Mit dem Gegenstekker zu dem zweiten Gerätestecker 5, dem sogenannten Fahrzeugstecker, ist ein weiterer Kabelbaum verbunden, der mit der Batterie, den Sensoren, Temperaturfühlern und weiteren Bauteilen im Kraftfahrzeuginneren verbunden ist.

Die zur Leitung von Signalströmen vorgesehenen Kontaktelemente 10 der Gerätestecker 4,5 sind über feine Bonddrähte 30 aus Gold, die in Fig. 1 durch dünne Linien gekennzeichnet sind, mit den Anschlußflächen 12 auf dem Substrat 2 verbunden. Von den Kontaktelementen 10 der Gerätestecker sind einige Kontaktelemente 11 zur Leitung von Leistungsströmen vorgesehen, auf die dicke Bonddrähte 40, 41, 42 aus Aluminium aufgebondet sind. In Fig. 1 ist zu erkennen, daß die meisten der Leistungsströme führenden Kontaktelemente 11 des Gerätesteckers 4 über Bonddrähte 42 mit Anschlußleiterbahnen 21 auf einem zweiten Substrat 3 verbunden sind. Das zweite Substrat 3 ist als DBC-Substrat oder Al₂O₃ Substrat gefertigt und in dem Gehäuse 1 neben dem ersten Substrat 2 zwischen den beiden Gerätesteckern 4,5 angeordnet. Die Leiterbahnen 20,21,23 auf dem zweiten Substrat 3 sind als großflächige, metallische Leiterbahnen aus Kupfer oder Silber gefertigt. Wie weiterhin in Fig. 1 zu erkennen ist, sind die von den Bonddrähten 42 abgewandten Enden der Anschlußleiterbahnen 21 als großflächige Anschlußflächen 21' ausgebildet. Auf jeder Anschlußfläche 21' ist als Leistungsbauelement ein Zündungstranssistor 60 direkt aufgebracht, wobei der Kollektor auf der Unterseite des Transistors die zugehörigen Anschlußleiterbahn 21 kontaktiert. Der Emitter 62 jedes Transistors 60 ist über einen Bonddraht 43 mit Masse verbunden. Die Basis 61 jedes Transistors 60 ist über Bonddrähte 45 mit der Schaltung auf dem ersten Substrat 2 verbunden. Vorteilhaft werden die Leistungsströme von den Leistungsbauelementen 60 über die metallischem Anschlußleiterbahnen 21 direkt zu den Bonddrähten 42 und den Kontaktelementen 11 des Gerätestekkers 4 und von dort über den motorseitigen Kabelbaum zu den Zündspulen abgeleitet.

Wie in Fig. 1 weiterhin erkennbar ist, können einige der Leistungsströme leitenden Kontaktelemente 11 zusätzlich auch in herkömmlicher Weise über Bonddrähte 40 mit Kontaktflächen 13 auf dem Hybridsubstrat 2 oder über Bonddrähte 46 mit dem Gehäuse 1 verbunden sein.

Weiterhin ist in Fig. 1 eine Durchführungsleiterbahn 20 auf dem DBC-Substrat 3 vorgesehen. Der dem Gerätestecker 5 zugewandte Endbereich 20' der Durchführungsleiterbahn 20 ist über einen Bonddraht 41 mit wenigstens einem Hochstromkontaktelement 11 des Gerätesteckers 5 verbunden. Der gegenüberliegende Endbereich 20" der Durchführungsleiterbahn 20 ist ohne Zwischenschaltung weiterer Bauelemente mit einem Kontaktelement 11 über einen Bonddraht 42 leitend verbunden ist. Entscheidend hierbei ist, daß über die Durchführungsleiterbahnen 20 hohe Leistungsströme ohne Zwischenschalten von Bauelementen direkt durch das Steuergerät hindurchgeführt bzw. "durchgeschleift" werden.

Weiterhin ist eine Leiterbahn 23 vorgesehen, deren einer Endbereich 23' über mehrere Bondrähte 41 mit Leistungsströme führenden Kontaktelementen 11 des zweiten Gerätesteckers 5 verbunden ist und deren gegenüberliegender Endbereich 23" über einen Bonddraht 44 mit einer Anschlußfläche 14 auf dem ersten Substrat 2 verbunden ist, die wiederum mit einem nichtgezeigten Leistungsbauelement auf dem ersten Substrat leitend verbunden ist. Da sich das Flächenstück 14 an dem dem Endbereich 23' gegenüberliegenden Ende des Hybrids 2 befindet, wird so erreicht, daß der Leistungsstrom im wesentlichen über die Leiterbahn 23 an ein mit dem Flächenstück 14 verbundenes Leistungsbauelement auf dem ersten Substrat 2 herangeführt werden kann. Der mit der Anschlußfläche 14 verbundene Endbereich 23" der Leiterbahn 23 ist weiterhin mit einem im Endbereich des DBC-Substrats aufgebrachten Kondensator 50 verbunden, über den Störströme auf das Flächenstück 25 und von dort über einen Bonddraht auf das Gehäuse 1 abgeleitet werden.

Darüber hinaus ist es möglich, auf dem zweiten Substrat (3) zusätzlich auch Signalströme führende Leiterbahnen (in Fig. 1 nicht dargestellt) vorzusehen, deren eines Ende mit einem Kontaktelement (10) eines Gerätesteckers (4,5) verbunden ist und deren anderes Ende mit Schaltungsanschlüssen auf dem ersten Substrat (2) leitend verbunden ist. Hierdurch läßt sich das Leiterbahnlayout auf dem ersten Substrat 2 weiter vereinfachen.

Weiterhin sind Chip-Dioden-Bauelemente 70 zur Begrenzung von Spannungsspitzen vorgesehen. Wie in Fig. 1 gezeigt, werden die Chip-Dioden-Bauelemente 70 mit der Anode auf der Oberseite oder der Unterseite auf eine Leiterbahn 22 des DBC-Substrats 3 aufgebracht. Die beiden Pole der Diode sind über Bonddrähte 47 und 48 mit der Leiterbahn 23 bzw. mit dem Gehäuseboden 1 verbunden. Bei einer Vertauschung der Pole der Diode wird die Diode über den Bonddraht 47 mit dem Gehäuse 1 und über den Bonddraht 48 mit der Leiterbahn 23 verbunden.

## Patentansprüche

1. Elektronisches Steuergerät mit einem Gehäuse (1), einem in dem Gehäuse angeordneten, eine elektronische Steuerschaltung aufweisendem Substrat (2), insbesondere einem Hybrid, und wenigstens einem an dem Gehäuse (1) festgelegten Gerätestecker (4) mit Kontaktelementen (10), die mit der Steuerschaltung des Substrats (2) elektrisch leitend verbunden sind, wobei räumlich getrennt von dem ersten Substrat (2) in dem Gehäuse (1) ein zweites Substrat (3) angeordnet ist, auf dem wenigstens ein mit der Steuerschaltung auf dem ersten Substrat (2) elektrisch verbundenes Leistungsbauelement (60) und eine mit dem Leistungsbauelement (60) leitend verbundene Anschlußleiterbahn (21) angeordnet ist, die mit einem Leistungsströme leitendem Kontaktelement (11) des Gerätesteckers (4) leitend verbunden ist, **dadurch gekennzeichnet, daß** ein zweiter Gerätestecker (5) mit Steckerelementen (10) an dem Gehäuse (1) angeordnet ist und daß auf dem zweiten Substrat (3) wenigstens eine zwischen dem ersten Gerätestecker (4) und dem zweiten Gerätestecker (5) verlaufende Durchführungsleiterbahn (20) vorgesehen ist, die ohne Zwischenschaltung von Bauelementen mit Leistungsströme führenden Kontaktelementen (11) der Gerätestecker (4,5) leitend verbunden ist.

2. Elektronisches Steuergerät nach Anspruch 1, **dadurch gekennzeichnet, daß** die elektrisch leitende Verbindung der Anschlußleiterbahnen (21) und Durchführungsleiterbahnen (20) des zweiten Substrats (3) mit den Kontaktelementen (11) des wenigstens einen Gerätesteckers (4,5) und die elektrische Verbindung des wenigstens einen Leistungsbauelements (60) mit der Steuerschaltung auf dem ersten Substrat (2) über Bonddrähte (41,42,45) erfolgt.

3. Elektronisches Steuergerät nach Anspruch 1, **dadurch gekennzeichnet, daß** auf dem zweiten Substrat (3) zusätzlich Leistungsströme führende Leiterbahnen (23) vorgesehen sind, deren eines Ende (23') mit einem Hochstromkontaktelement (11) eines Gerätesteckers (4,5) und deren anderes Ende (23") mit einer Kontaktflächen (14) auf dem ersten Substrat (2) leitend verbunden ist.

4. Elektronisches Steuergerät nach Anspruch 1, **dadurch gekennzeichnet, daß** auf dem zweiten Substrat (3) zusätzlich Signalströme führende Leiterbahnen vorgesehen sind, deren eines Ende mit einem Kontaktelement (10) eines Gerätesteckers (4,5) verbunden ist und deren anderes Ende mit Schaltungsanschlüssen auf dem ersten Substrat (2) leitend verbunden ist.

5. Elektronisches Steuergerät nach Anspruch 1, **dadurch gekennzeichnet, daß** die Durchführungsleiterbahnen (20) und/oder die zusätzliche Leiterbahn (23) des zweiten Substrats (3) an ihrem einen Endbereich (20", 23'') mit einem Kondensator (50) versehen ist.

6. Elektronisches Steuergerät nach einem der vorstehenden Ansprüche, **dadurch gekennzeichnet, daß** das zweite Substrat (3) ein DBC-Substrat (Direct-Bonded-Copper-Substrat) ist, welches aus einer gut wärmeleitende keramischen Trägerplatte besteht, auf deren Oberseite vorzugsweise aus Kupfer bestehende, metallische Leiterbahnstrukturen aufgebracht sind.

7. Elektronisches Steuergerät nach einem der vorstehenden Ansprüche, **dadurch gekennzeichnet, daß** das zweite Substrat (3) ein Al₂O₃ Keramiksubstrat mit aus Silber gebildeten Leiterbahnstrukturen ist.

8. Elektronisches Steuergerät nach Anspruch 6 oder 7, **dadurch gekennzeichnet, daß** auf dem zweiten Substrat (3) wenigstens ein von den Durchführungsleiterbahnen (20) und den Anschlußleiterbahnen (21) isoliertes Chip-Dioden-Bauelement (70) vorgesehen ist, wobei wahlweise Dioden-Baulemente mit der Anode oder der Kathode auf der dem zweiten Substrat zugewandten Unterseite des Dioden-Baulementes vorgesehen werden können.

## Claims

1. Electronic control device having a housing (1), a substrate (2), in particular a hybrid, which is arranged in the housing and has an electronic control circuit, and at least one device connector (4) which is fixed to the housing (1) and has contact elements (10) which are electrically conductively connected to the control circuit of the substrate (2), with a second substrate (3) being arranged in the housing (1) such that it is physically separate from the first substrate (2), and at least one power component (60), which is electrically connected to the control circuit on the first substrate (2), and a connection conductor track (21), which is conductively connected to the power component (60), and is conductively connected to a contact element (11), which conducts power currents, of the device connector (4), being arranged on the said second substrate, **characterized in that** a second device connector (5) with connector elements (10) is arranged on the housing (1), and **in that** at least one lead-through conductor track (20), which runs between the first device connector (4) and the second device connector (5) and is conductively connected to contact elements (11), which carry power currents, of the device connectors (4, 5) without the interposition of components, is provided on the second substrate (3).

2. Electronic control device according to Claim 1, **characterized in that** the connection conductor tracks (21) and lead-through conductor tracks (20) of the second substrate (3) are electrically conductively connected to the contact elements (11) of the at least one device connector (4, 5) and the at least one power component (60) is electrically connected to the control circuit on the first substrate (2) via bonding wires (41, 42, 45).

3. Electronic control device according to Claim 1, **characterized in that** conductor tracks (23) which carry power currents are additionally provided on the second substrate (3), and one end (23') of the said conductor tracks is conductively connected to a high-current contact element (11) of a device connector (4, 5) and the other end (23") of the said conductor tracks is conductively connected to a contact area (14) on the first substrate (2).

4. Electronic control device according to Claim 1, **characterized in that** conductor tracks which carry signal currents are additionally provided on the second substrate (3), and one end of the said conductor tracks is connected to a contact element (10) of a device connector (4, 5) and the other end of the said conductor tracks is conductively connected to circuit connections on the first substrate (2).

5. Electronic control device according to Claim 1, **characterized in that** the lead-through conductor tracks (20) and/or the additional conductor track (23) of the second substrate (3) are/is provided with a capacitor (50) at one end region (20'', 23").

6. Electronic control device according to one of the preceding claims, **characterized in that** the second substrate (3) is a DBC substrate (direct bonded copper substrate) which comprises a highly thermally conductive ceramic support plate which has metallic conductor track structures, which are preferably composed of copper, applied to its upper face.

7. Electronic control device according to one of the preceding claims, **characterized in that** the second substrate (3) is an Al₂O₃ ceramic substrate with conductor track structures which are formed from silver.

8. Electronic control device according to Claim 6 or 7, **characterized in that** at least one chip diode component (70) which is insulated from the lead-through conductor tracks (20) and the connection conductor tracks (21) is provided on the second substrate (3), it being possible for diode components with the anode or the cathode on the lower face, which faces the second substrate, of the diode component to optionally be provided.

## Revendications

1. Appareil de commande électronique comprenant un boîtier (1), un substrat (2) avec un circuit de commande électronique installé dans le boîtier, notamment un circuit hybride, et au moins un connecteur d'appareils (4) à éléments de contact (10), fixé dans le boîtier (1), ces éléments de contact étant reliés électriquement au circuit de commande du substrat (2) selon lequel
le boîtier (1) comporte un second substrat (3), séparé dans l'espace, par rapport au premier substrat (2), et le second substrat comporte au moins un composant de puissance (60) relié électriquement au circuit de commande du premier substrat (2) et un chemin conducteur de branchement (21) relié électriquement au composant de puissance (60), ce chemin de branchement étant relié électriquement à l'élément de contact (11) du connecteur d'appareil (4) pour les courants forts,
**caractérisé par**
un second connecteur d'appareil (5) muni d'éléments de connexion (10) prévus sur le boîtier (1) et
le second substrat (3) comporte au moins un chemin conducteur de passage (20) entre le premier connecteur d'appareil (4) et le second connecteur d'appareil (5), ce chemin conducteur reliant électriquement et sans interposition de composant, les éléments de contact (11) de courant fort des connecteurs d'appareil (4, 5).

2. Appareil de commande électronique selon la revendication 1,
**caractérisé en ce que**
la liaison conductrice des chemins de branchement (21) et des chemins conducteurs de passage (20) du second substrat (3) sont reliées aux éléments de contact (11) d'au moins un connecteur d'appareil (4, 5) et la liaison électrique d'au moins un composant de puissance (60) avec le circuit de commande sur le premier substrat (2) se fait par des fils de liaison (41, 42, 45).

3. Appareil de commande électronique selon la revendication 1,
**caractérisé en ce que**
le second substrat (3) porte en outre des chemins conducteurs (23) pour les courants forts, chemins dont une extrémité (23') est reliée à un élément de contact de courant fort (11) d'un connecteur d'appareils (4, 5) et son autre extrémité (23") est reliée électriquement à une surface de contact (14) du premier substrat (2).

4. Appareil de commande électronique selon la revendication 1,
**caractérisé en ce que**
le second substrat (15) comporte en plus des chemins conducteurs pour les courants des signaux, chemins dont une extrémité est reliée à un élément de contact (10) d'un connecteur d'appareils (4, 5) et dont l'autre extrémité est reliée électriquement aux bornes de circuit du premier substrat (2).

5. Appareil de commande électronique selon la revendication 1,
**caractérisé en ce que**
les chemins de passage (20) et/ou le chemin conducteur supplémentaire (23) du second substrat (3) comportent un condensateur (50) à l'une de leurs zones d'extrémité (20", 23").

6. Appareil de commande électronique selon l'une des revendications précédentes,
**caractérisé en ce que**
le second substrat (3) est un substrat DBC (substrat direct à liaison en cuivre) formé d'une plaque de support en céramique bonne thermo-conductrice, et dont la face supérieure porte des structures de chemins conducteurs métalliques, de préférence en cuivre.

7. Appareil de commande électronique selon l'une des revendications précédentes,
**caractérisé en ce que**
le second substrat (3) est un substrat en céramique (Al₂O₃) avec des structures de chemins conducteurs en argent.

8. Appareil de commande électronique selon les revendications 6 ou 7,
**caractérisé en ce que**
le second substrat (3) comporte au moins un composant (70) isolé par des diodes de plaquette par rapport aux chemins conducteurs passants (20) et au chemins de branchement (21), et des composants diodes dont l'anode ou la cathode est sur la face inférieure du composant diode tourné vers le second substrat.
